(19) Europäisches Patentamt
European Patent Office
Office européen des brevets

(11) **EP 2 441 172 B1**

(12) **EUROPÄISCHE PATENTSCHRIFT**

(45) Veröffentlichungstag und Bekanntmachung des Hinweises auf die Patenterteilung:
**12.09.2018 Patentblatt 2018/37**

(21) Anmeldenummer: **10716818.9**

(22) Anmeldetag: **23.04.2010**

(51) Int Cl.:
**H03H 11/12** *(2006.01)* **H03H 11/04** *(2006.01)*
**H03H 11/48** *(2006.01)*

(86) Internationale Anmeldenummer:
**PCT/EP2010/055447**

(87) Internationale Veröffentlichungsnummer:
**WO 2010/142487 (16.12.2010 Gazette 2010/50)**

(54) **ANALOGER FILTER MIT EINSTELLBARER MITTENFREQUENZ**

ANALOG BAND-PASS FILTER HAVING ADJUSTABLE CENTER FREQUENCY

FILTRE PASSE-BANDE ANALOGIQUE À FRÉQUENCE CENTRALE AJUSTABLE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **10.06.2009 DE 102009026885**

(43) Veröffentlichungstag der Anmeldung:
**18.04.2012 Patentblatt 2012/16**

(73) Patentinhaber: **Endress+Hauser SE+Co. KG 79689 Maulburg (DE)**

(72) Erfinder:
• **GROZINGER, Roland**
**79129 Staufen (DE)**
• **KEMPA, Arnd**
**79585 Steinen (DE)**

(74) Vertreter: **Andres, Angelika Maria
Endress+Hauser (Deutschland) AG+Co. KG
PatServe
Colmarer Strasse 6
79576 Weil am Rhein (DE)**

(56) Entgegenhaltungen:
**US-A- 4 383 230 US-A- 4 516 041
US-A- 4 644 306**

• **Tony R. Kuphaldt: "Lessons in Electric Circuits, Volume II - AC" 25. Juli 2007 (2007-07-25), Seiten 189-216, XP002603449 Gefunden im Internet: URL:http://www.allaboutcircuits.com/pdf/AC .pd f [gefunden am 2010-10-05]**
• **KARASCH H ET AL: "VOLTAGE CONTROLLED HARMONIC FILTER" MOTOROLA TECHNICAL DEVELOPMENTS, MOTOROLA INC. SCHAUMBURG, ILLINOIS, US, Bd. 32, 1. September 1997 (1997-09-01), Seiten 37-40, XP000741118 ISSN: 0887-5286**
• **ALI TOMBAK ET AL: "Voltage-Controlled RF Filters Employing Thin-Film Barium-Strontium-Titanate Tunable Capacitors" IEEE TRANSACTIONS ON MICROWAVE THEORY AND TECHNIQUES, IEEE SERVICE CENTER, PISCATAWAY, NJ, US, Bd. 51, Nr. 2, 1. Februar 2003 (2003-02-01), XP011076898 ISSN: 0018-9480**

**Beschreibung**

Die Erfindung betrifft ein Bandpassfilter mit einstellbarer Mittenfrequenz.

Es gibt eine Vielzahl von elektronischen Schaltungen, in denen analoge Filter mit einstellbarer Frequenz eingesetzt werden.

Ein typisches Beispiel sind Schaltungen von Messgeräten, in denen diese Filter beispielsweise zur Filterung von mit einem Sensor aufgenommenen Messsignalen verwendet werden.

Hierzu zählen mit Ultraschall arbeitende Füllstandsmessgeräte, bei denen vorzugsweise bei deren Resonanzfrequenz betriebene Ultraschallsensoren kurze Ultraschallwellenimpulse in Richtung des Füllguts senden und deren von der Oberfläche des Füllguts zum Sensor zurück reflektierten Echosignale nach einer vom Füllstand abhängigen Laufzeit empfangen. Dabei wird vom Sensor nicht nur das gewünschte die Resonanzfrequenz aufweisende Nutzsignal empfangen sondern auch Störsignale. Die Störsignale weisen in der Regel von der Resonanzfrequenz verschiedene Störfrequenzen auf, und werden durch entsprechende Filterung unterdrückt. Hierzu wird aus dem Empfangssignal des Sensors mittels eines auf die Resonanzfrequenz des Ultraschallsensors abgestimmten Bandpassfilters ein Messsignal herausgefiltert. Die Resonanzfrequenzen sind jedoch von Sensor zu Sensor unterschiedlich und in der Regel von der Temperatur abhängig. Um den gesamten Bereich der möglicher Weise auftretenden Resonanzfrequenzen abdecken zu können, werden hier beispielsweise Bandpässe mit einer festen Mittenfrequenz und einer sehr großen Bandbreite eingesetzt. Dabei ist die Störsignalunterdrückung jedoch umso schlechter, je größer die Bandbreite des Bandpasses ist.

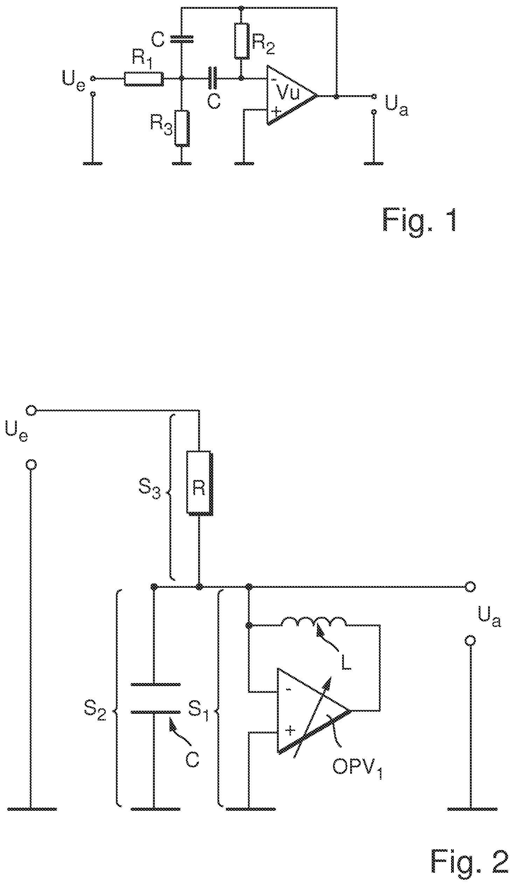

Alternativ werden einstellbare Bandpassfilter eingesetzt. Ein Beispiel sind aktive Bandpässe mit Mehrfachgegenkopplung, bei denen die Mittenfrequenz über veränderbare Widerstände einstellbar ist. Fig. 1 zeigt ein Ausführungsbeispiel hierzu. Dort liegt eine auf ein Bezugspotential bezogene Eingangsspannung $U_e$ über einen ersten Widerstand $R_1$ und einen in Reihe dazu geschalteten ersten Kondensator C an einem invertierenden Eingang eines Verstärker $V_u$ mit konstanter Verstärkung an. Der nicht invertierende Eingang des Verstärkers $V_u$ liegt an dem Bezugspotential an. Ein Ausgangssignal des Verstärkers $V_u$ wird über einen zweiten Kondensator C gleicher Kapazität auf einen ersten zwischen dem ersten Widerstand $R_1$ und dem ersten Kondensator C befindlichen Abgriff und parallel dazu über einen zweiten Widerstand $R_2$ auf einen zweiten zwischen dem ersten Kondensator C und dem invertierenden Eingang befindlichen Abgriff zurückgeführt. Zusätzlich liegt der erste Abgriff über einen dritten Widerstand $R_3$ an dem Bezugspotential an. Ausgangssignal dieses Bandpassfilters ist die am Ausgang des Verstärkers $V_u$ vorliegende Ausgangsspannung $U_a$ bezogen auf das Bezugspotential. Diese Filter weisen jedoch aufgrund der Widerstände ein hohes Rauschen auf, das gerade bei der Filterung von Messsignalen, wie sie z.B. bei Ultraschall Füllstandsmessgeräten ausgeführt wird, sehr störend ist.

Demgegenüber weisen passive Filter ein sehr viel geringeres Rauschen auf. Dort besteht jedoch der Nachteil, dass die Filterfrequenz nur durch zu- oder wegschalten von die Filterfrequenz bestimmenden Induktivitäten und Kapazitäten, bzw. durch mechanisch verstellbare Induktivitäten und Kapazitäten verändert werden kann. Ein solches einstellbares Filter ist beispielsweise in der DE 10 2006 052 873 A1 beschrieben. Kernstück des dort beschriebenen Filters ist ein LC-Schwingkreis, der eine Induktivität und eine verstimmbare Kapazität, insb. eine Varaktordiode, umfasst. Varaktordioden weisen jedoch kleine Kapazitäten, z. B. in der Größenordnung von einigen Pikofarad auf, so dass diese Filter nur zur Filterung von Signalen mit sehr hohen Frequenzen geeignet sind.

In der Veröffentlichungsschrift US 4 516 041 A ist eine durch Spannung steuerbare Kapazität auf Basis eines Operationsverstärkers beschrieben. Eine per Programmierung steuerbare Kapazität wird in der US- Anmeldung 04644306 A1 gezeigt. Die Programmierbarkeit wird in diesem Fall durch einen programmierbaren Operationsverstärker erreicht.

Die Veröffentlichungsschrift US 4 383230 A zeigt ein aktives Bandpassfilter auf Basis von Trankonduktanz-Verstärkem.

Es ist eine Aufgabe der Erfindung, ein rauscharmes analoges Bandpassfilter mit einstellbarer Mittenfrequenz anzugeben.

Hierzu besteht die Erfindung in einem analogen Bandpassfilter mit einstellbarer Mittenfrequenz mit

-  einem Parallelschwingkreis,

> -- dessen Resonanzfrequenz gleich der Mittenfrequenz des Filters ist,
> -- der einen ersten Schaltungszweig aufweist, in dem ein erstes frequenzbestimmendes Element angeordnet ist,
> -- der einen parallel zu dem ersten Schaltungszweig geschalteten zweiten Schaltungszweig aufweist, in dem ein zweites frequenzbestimmendes Element angeordnet ist, wobei
> -- das erste frequenzbestimmende Element eine Kapazität und das zweite frequenzbestimmende Element eine Induktivität ist, und

-  einem in den ersten Schaltungszweig eingesetzten ersten Verstärker mit einstellbarer Verstärkung und einem in den zweiten Schaltungszweig eingesetzten zweiten Verstärker mit einstellbarer Verstärkung,

> -- wobei der Ausgang der ersten Verstärker über das erste frequenzbestimmende Element mit dem invertierenden Eingang der ersten Verstärker verbunden ist, und der Ausgang der zweiten Verstärker über das zweite frequenzbestimmende Element mit dem invertierenden Eingang der zweiten Verstärker verbunden ist, und -- wobei die Verstärker im Betrieb eine über das in diesem Schaltungszweig angeordnete frequenzbestimmende Element anliegende Spannung der eingestellten Verstärkung entsprechend verstärken und dadurch eine entsprechende Veränderung eines durch dieses frequenzbestimmende Element fließenden Stroms bewirken.

Gemäß einer ersten Ausgestaltung ist die eingestellte Verstärkung größer als 1 und der Verstärker erhöht den durch das frequenzbestimmende Element fließenden Strom.

Gemäß einer zweiten Ausgestaltung ist die eingestellte Verstärkung kleiner als 1 und der Verstärker erniedrigt den durch das frequenzbestimmende Element fließenden Strom.

Gemäß einer Ausgestaltung ist ein Ausgangssignal des Filters eine Ausgangsspannung, die über den Schwingkreis abfällt.

Gemäß einer weiteren Ausgestaltung ist ein Eingangssignal des Filters eine Eingangsspannung, die über einen dritten dem Schwingkreis in Serie vorgeschalteten Schaltungszweig, in dem ein Widerstand angeordnet ist, an dem Schwingkreis anliegt.

Gemäß einer anderen Ausgestaltung ist ein Eingangssignal des Filters ein Eingangsstrom, und dem Schwingkreis ist ein weiterer Schaltungszweig vorgeschaltet, der parallel zum Schwingkreis geschaltet ist, und in dem ein Widerstand angeordnet ist.

Die Erfindung und weitere Vorteile werden nun anhand der Figuren der Zeichnung, in denen zehn Ausführungsbeispiele dargestellt sind, näher erläutert; gleiche Elemente sind in den Figuren mit gleichen Bezugszeichen versehen.

Fig. 1 zeigt:     ein aus dem Stand der Technik bekanntes aktives Bandpassfilter mit Mehrfachgegenkopplung;

Fig. 2 zeigt:     eine erste Ausführung eines Bandpassfilters, mit einem Parallelschwingkreis, in dem eine über eine Induktivität des Parallelschwingkreises anliegende Spannung mittels eines einstellbaren Verstärkers verstärkt wird und dadurch eine entsprechende Veränderung eines durch die Induktivität fließenden Stroms bewirkt wird;

Fig. 3 zeigt:     eine zweite Ausführung eines Bandpassfilters, mit einem Parallelschwingkreis, in dem eine über eine Kapazität des Parallelschwingkreises anliegende Spannung mittels eines einstellbaren Verstärker verstärkt wird und dadurch eine entsprechende Veränderung eines durch die Kapazität fließenden Stroms bewirkt wird;

Fig. 4 zeigt:     eine erste Ausführung eines erfindungsgemäßen Bandpassfilters, mit einem Parallelschwingkreis, bei dem in beiden Schaltungszweigen jeweils ein Verstärker angeordnet ist;

Fig. 5 zeigt:     eine erste Ausführung einer Bandsperre, mit einem Serienschwingkreis, in dem eine über eine Induktivität des Serienschwingkreises anliegende Spannung mittels eines einstellbaren Verstärker verstärkt wird und dadurch eine entsprechende Veränderung eines durch die Induktivität fließenden Stroms bewirkt wird;

Fig. 6 zeigt:     eine zweite Ausführung einer Bandsperre, mit einem Serienschwingkreis, in dem eine über eine Kapazität des Serienschwingkreises anliegende Spannung mittels eines einstellbaren Verstärker verstärkt wird und dadurch eine entsprechende Veränderung eines durch die Kapazität fließenden Stroms bewirkt wird;

Fig. 7 zeigt:     einen über eine Stromquelle gespeisten Filter gemäß Fig. 2;

Fig. 8 zeigt:     einen über eine Stromquelle gespeisten Filter gemäß Fig. 3;

Fig. 9 zeigt:     einen über eine Stromquelle gespeisten erfindungsgemäßen Filter gemäß Fig. 4;

Fig. 10 zeigt:     einen über eine Stromquelle gespeisten Filter gemäß Fig. 5;

Fig. 11 zeigt:     einen über eine Stromquelle gespeisten Filter gemäß Fig. 6;

Fig. 12 zeigt:     das Quadrat der spektralen Energiedichte des Rauschens des in Fig. 2 dargestellten erfindungsgemäßen passiven Bandpassfilters in Abhängigkeit von der Frequenz; und

Fig. 13 zeigt:     das Quadrat der spektralen Energiedichte des Rauschens des in Fig. 1 dargestellten herkömmlichen aktiven Bandpassfilters in Abhängigkeit von der Frequenz.

Die in Fig. 2, 3 und 4 dargestellten Filter sind Bandpassfilter und die Filterfrequenz ist die Mittenfrequenz des Bandpassfilters. Kernstück der Filter ist jeweils ein Schwingkreis, dessen Resonanzfrequenz $f_0$ gleich der Filterfrequenz des jeweiligen Filters ist. Der Schwingkreis weist zwei parallel zueinander geschaltete Schaltungszweige S1, S2 auf, in denen jeweils ein frequenzbestimmendes Element angeordnet ist, von denen eins eine Induktivität L und eins eine Kapazität C ist. In den hier dargestellten Bandpassfiltern ist in dem ersten Schaltungszweig S1 die Induktivität L und in dem parallel dazu geschalteten zweiten Schaltungszweig S2 die Kapazität C angeordnet.

Beide Schaltungszweige S1, S2 sind eingangsseitig an einen dritten Schaltungszweig S3 angeschlossen, in dem ein Widerstand R angeordnet ist. Ein Eingangssignal des Filters, hier eine auf ein festes Bezugspotential, z.B. Masse, bezogene Eingangsspannung $U_e$, liegt über diesen dritten Schaltungszweig S3 eingangsseitig an dem Parallelschwingkreis an. Der zweite und der dritte Schaltungszweig S2, S3 liegen ausgangsseitig ebenfalls an diesem festen Bezugspotential. Am Ausgang des Filters steht die über den Schwingkreis abfallende auf das Bezugspotential bezogene Ausgangsspannung $U_a$ als gefiltertes Ausgangssignal zur Verfügung.

In einen der beiden Schaltungszweige S1 oder S2 ist ein Verstärker $OPV_1$ bzw. $OPV_2$ mit einstellbarer Verstärkung $V_L$ bzw. $V_C$ eingesetzt, dessen Ausgang über das in diesem Schaltungszweig S1, S2 angeordnete frequenzbestimmende Element an dessen invertierenden Eingang angeschlossen ist. Der nicht invertierende Eingang des Verstärkers $OPV_1$ bzw. $OPV_2$ ist an das Bezugspotential angeschlossenen. Der Verstärker $OPV_1$ bzw. $OPV_2$ verstärkt im Filterbetrieb eine über das in diesem Schaltungszweig S1 oder S2 angeordnete frequenzbestimmende Element abfallende Spannung entsprechend der eingestellten Verstärkung $V_L$ bzw. Vc und bewirkt dadurch eine entsprechende Veränderung eines durch dieses frequenzbestimmende Element fließenden Stroms. Ist die eingestellte Verstärkung $V_L$ bzw. Vc größer als 1, so wird durch den Verstärker $OPV_1$ bzw. $OPV_2$ der durch das frequenzbestimmende Element fließenden Strom erhöht. Ist die eingestellte Verstärkung $V_L$ bzw. $V_C$ kleiner als 1, so wird durch den Verstärker $OPV_1$ bzw. $OPV_2$ der durch das frequenzbestimmende Element fließenden Strom erniedrigt.

Der Verstärker $OPV_1$ bzw. $OPV_2$ ist vorzugsweise ein Operationsverstärker, dessen Verstärkung $V_L$ bzw. Vc beispielsweise mittels eines hier durch einen Pfeil symbolisierten digitalen Potentiometers einstellbar ist.

Bei dem in Fig. 2 dargestellten Ausführungsbeispiel ist der Verstärker $OPV_1$ in den ersten Schaltungszweig S1 eingesetzt und an die Induktivität L angeschlossen. Diese Kombination aus Induktivität L und Verstärker $OPV_1$ wirkt damit wie eine einstellbare Induktivität $L_{eff}$ der Größe:

$$L_{eff} = \frac{L}{V_L + 1}$$

Hierdurch ergibt sich eine über die Verstärkung $V_L$ einstellbare Resonanzfrequenz $f_0$ des Parallelschwingkreises von:

$$f_0 = \frac{1}{2\pi\sqrt{\dfrac{LC}{V_L + 1}}}$$

Die Mittenfrequenz dieses Bandpassfilters ist gleich der Resonanzfrequenz $f_0$ dieses Schwingkreises und anhand der Verstärkung $V_L$ automatisch einstellbar.

Für die Bandbreite B des in Fig. 2 dargestellten Bandpassfilters gilt:

$$B = \frac{1}{2\pi RC}$$

Die Bandbreite B ist damit über den Widerstand R unabhängig von der Resonanzfrequenz $f_0$ des Filters einstellbar.

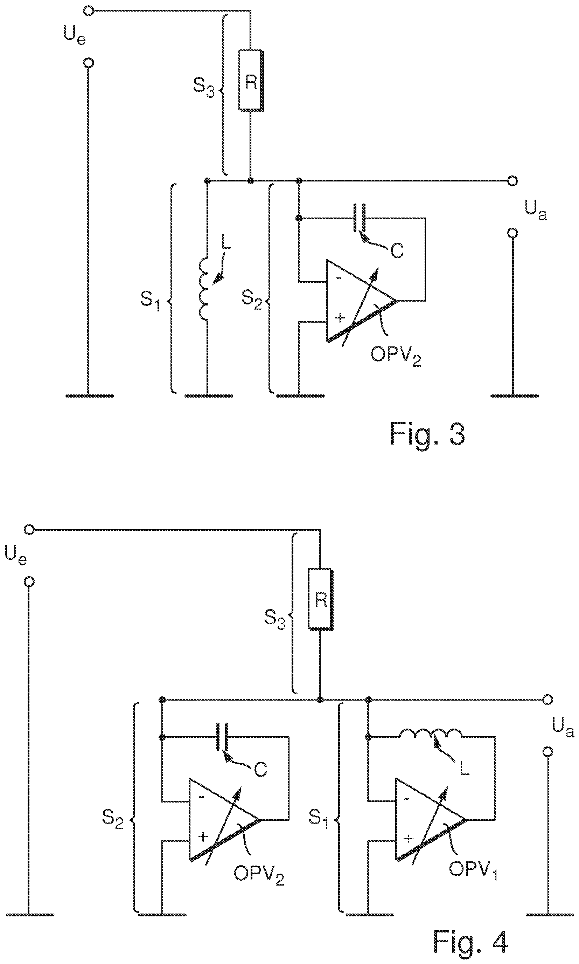

Bei dem in Fig. 3 dargestellten Ausführungsbeispiel ist der Verstärker $OPV_2$ in den zweiten Schaltungszweig S2 eingesetzt und an die Kapazität C angeschlossen. Diese Kombination aus Kapazität C und Verstärker $OPV_2$ wirkt damit wie eine einstellbare Kapazität $C_{eff}$ der Größe:

$$C_{eff} = C\left(V_C + 1\right)$$

Hierdurch ergibt sich eine über die Verstärkung $V_C$ einstellbare Resonanzfrequenz $f_0$ des Parallelschwingkreises von:

$$f_0 = \frac{1}{2\pi\sqrt{LC\left(V_C + 1\right)}}$$

Die Mittenfrequenz dieses Bandpassfilters ist gleich der Resonanzfrequenz $f_0$ dieses Schwingkreises und anhand der Verstärkung $V_C$ automatisch einstellbar.

Für die Bandbreite B des in Fig. 3 dargestellten Bandpassfilters gilt:

$$B = \frac{1}{2\pi RC\left(V_C + 1\right)}$$

Die Bandbreite B ist damit vom Widerstand R und von der Resonanzfrequenz $f_0$ des Filters abhängig.

Bei dem in Fig. 4 dargestellten Ausführungsbeispiel ist sowohl in dem ersten Schaltungszweig S1 als auch in dem zweiten Schaltungszweig S2 jeweils ein Verstärker OPV$_1$, OPV$_2$ mit einstellbarer Verstärkung V$_L$, V$_C$ eingesetzt, dessen Ausgang über das in dem jeweiligen Schaltungszweig S1, S2 angeordnete frequenzbestimmende Element mit dessen invertierendem Eingang verbunden ist, und der im Filterbetrieb die über das in diesem Schaltungszweig S1, S2 angeordnete frequenzbestimmende Element anliegende Spannung entsprechend der eingestellten Verstärkung V$_L$, V$_C$ verstärkt und dadurch eine entsprechende Veränderung des durch das jeweilige frequenzbestimmende Element fließenden Stroms bewirkt. Auch hier erhöht sich der jeweilige Strom, wenn die zugehörige Verstärkung V$_L$ bzw. V$_C$ größer als 1 ist, und er erniedrigt sich, wenn die zugehörige Verstärkung V$_L$ bzw. V$_C$ kleiner als 1 ist.

Damit ergibt sich eine einstellbare Induktivität L$_{eff}$ der Größe:

$$L_{eff} = \frac{L}{V_L + 1}$$

und eine einstellbare Kapazität C$_{eff}$ der Größe:

$$C_{eff} = C(V_C + 1)$$

Dementsprechend ergibt sich eine über die Verstärkungen V$_L$ und V$_C$ einstellbare Resonanzfrequenz f$_0$ dieses Parallelschwingkreises von:

$$f_0 = \frac{1}{2\pi \sqrt{\dfrac{LC(V_C + 1)}{V_L + 1}}}$$

Hierdurch kann ein deutlich größerer Frequenzbereich der einstellbaren Filterfrequenzen abgedeckt werden. Dabei werden die Verstärkungen V$_L$, V$_C$ gegenläufig gesteuert, damit sich deren Effekte nicht gegenseitig aufheben.

Für die Bandbreite B des in Fig. 4 dargestellten Bandpassfilters gilt:

$$B = \frac{1}{2\pi RC(V_C + 1)}$$

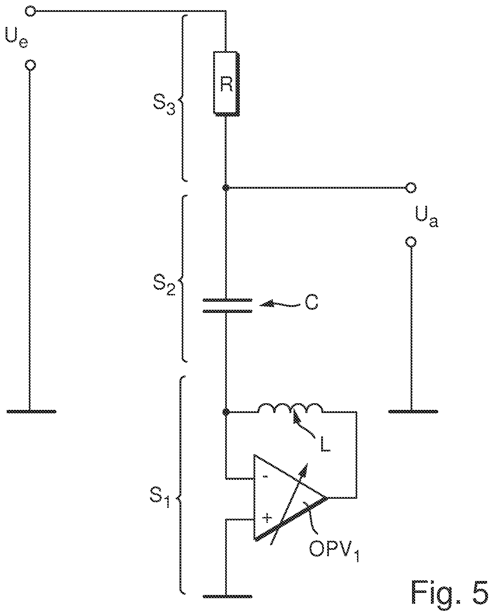

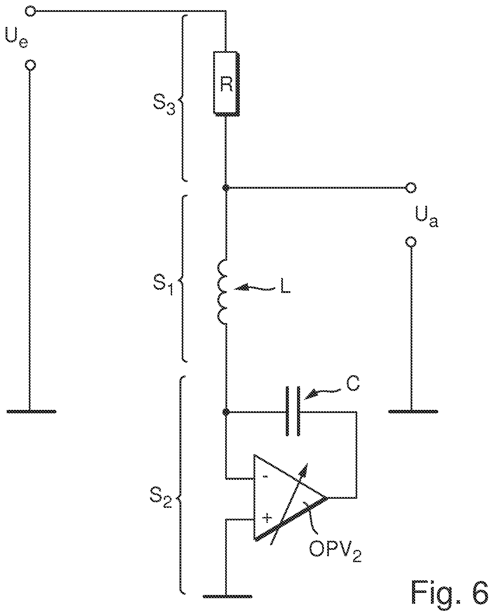

Fig. 5 und 6 zeigen zwei Ausführungsbeispiele einer zweiten Variante eines erfindungsgemäßen passiven analogen Filters mit einstellbarer Filterfrequenz. Die dort dargestellten Filter sind Bandsperren und die Filterfrequenz ist die Sperrfrequenz der Bandsperre. Kernstück der Filter ist auch hier jeweils ein Schwingkreis, dessen Resonanzfrequenz f$_0$ gleich der Filterfrequenz des Schaltungszweige S1, S2 aufweist, in denen jeweils ein frequenzbestimmendes Element angeordnet ist, von denen eins eine Induktivität L und eins eine Kapazität C ist. In den hier dargestellten Bandsperren ist in dem ersten Schaltungszweig S1 die Induktivität L und in dem in Serie dazu geschalteten zweiten Schaltungszweig S2 die Kapazität C angeordnet.

Den beiden in Serie angeordneten Schaltungszweige S1, S2 ist eingangsseitig ein dritter Schaltungszweig S3 vorgeschaltet, in dem ein Widerstand R angeordnet ist. Das Eingangssignal des Filters ist auch hier eine auf ein festes Bezugspotential, z.B. Masse, bezogene Eingangsspannung U$_e$, die über diesen dritten Schaltungszweig S3 eingangsseitig an dem Serienschwingkreis anliegt. Der Serienschwingkreis liegt ausgangsseitig ebenfalls an diesem festen Bezugspotential und am Ausgang des Filters steht die über den Schwingkreis abfallende auf das Bezugspotential bezogene Ausgangsspannung U$_a$ als gefiltertes Ausgangssignal zur Verfügung.

Auch hier ist in einen der beiden Schaltungszweige S1 oder S2 ein Verstärker OPV$_1$, OPV$_2$ mit einstellbarer Verstärkung V$_L$, Vc eingesetzt, dessen Ausgang über das in diesem Schaltungszweig S1, S2 angeordnete frequenzbestimmende Element an dessen invertierenden Eingang angeschlossen ist. Der nicht invertierende Eingang des Verstärkers OPV$_1$ bzw. OPV$_2$ ist an das Bezugspotential angeschlossen. Der Verstärker OPV$_1$, OPV$_2$ verstärkt im Filterbetrieb eine über das in diesem Schaltungszweig S1 oder S2 angeordnete frequenzbestimmende Element abfallende Spannung entsprechend der eingestellten Verstärkung V$_L$ bzw. Vc und bewirkt dadurch eine entsprechende Veränderung des über dieses Element fließenden Stroms. Ist die eingestellte Verstärkung V$_L$ bzw. V$_C$ größer als 1, so wird durch den Verstärker OPV$_1$ bzw. OPV$_2$ der durch das frequenzbestimmende Element fließenden Strom erhöht. Ist die eingestellte Verstärkung V$_L$ bzw. Vc kleiner als 1, so wird durch den Verstärker OPV$_1$ bzw. OPV$_2$ der durch das frequenzbestimmende Element fließenden Strom erniedrigt.

Der Verstärker OPV$_1$, OPV$_2$ ist auch hier vorzugsweise ein Operationsverstärker, dessen Verstärkung V$_L$, V$_C$ beispielsweise mittels eines hier durch einen Pfeil symbolisierten digitalen Potentiometers einstellbar ist.

Bei dem in Fig. 5 dargestellten Ausführungsbeispiel ist der Verstärker OPV$_1$ in den ersten Schaltungszweig S1 eingesetzt und an die Induktivität L angeschlossen. Diese Kombination aus Induktivität L und Verstärker OPV$_1$ wirkt damit wie eine einstellbare Induktivität L$_{eff}$ der Größe:

$$L_{eff} = \frac{L}{V_L + 1}$$

Hierdurch ergibt sich eine über die Verstärkung $V_L$ einstellbare Resonanzfrequenz $f_0$ des Serienschwingkreises von:

$$f_0 = \frac{1}{2\pi\sqrt{\dfrac{LC}{V_L+1}}}$$

Die Sperrfrequenz dieser Bandsperre ist gleich der Resonanzfrequenz $f_0$ dieses Schwingkreises und anhand der Verstärkung $V_L$ automatisch einstellbar.

Mit dem in Serie zu dem Serienschwingkreis geschalteten Widerstand R ergibt sich die Bandbreite B der in Fig. 5 dargestellten Bandsperre zu:

$$B = \frac{R(V_L+1)}{2\pi L}$$

Die Bandbreite B ist damit vom Widerstand R und von der Resonanzfrequenz $f_0$ des Filters abhängig.

Bei dem in Fig. 6 dargestellten Ausführungsbeispiel ist der Verstärker $OPV_2$ in den zweiten Schaltungszweig S2 eingesetzt und an die Kapazität C angeschlossen. Diese Kombination aus Kapazität C und Verstärker $OPV_2$ wirkt damit wie eine einstellbare Kapazität $C_{eff}$ der Größe:

$$C_{eff} = C(V_C+1))$$

Hierdurch ergibt sich eine über die Verstärkung V einstellbare Resonanzfrequenz $f_0$ des Serienschwingkreises von:

$$f_0 = \frac{1}{2\pi\sqrt{LC(V_C+1)}}$$

Die Sperrfrequenz dieser Bandsperre ist gleich der Resonanzfrequenz $f_0$ des Serienschwingkreises und anhand der Verstärkung $V_C$ automatisch einstellbar.

Für die Bandbreite B der in Fig. 6 dargestellten Bandsperre gilt:

$$B = \frac{R}{2\pi L}$$

Die Bandbreite B ist damit über den Widerstand R unabhängig von der Resonanzfrequenz $f_0$ des Filters einstellbar.

Anstelle einer Eingangsspannung $U_e$ kann den erfindungsgemäßen analogen Filtern natürlich auch ein Eingangsstrom $I_e$ als Eingangssignal zugeführt werden.

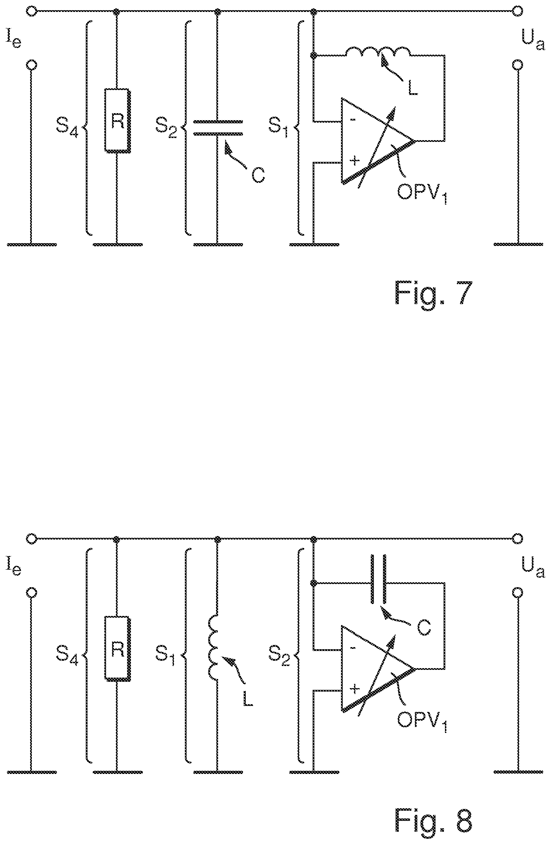

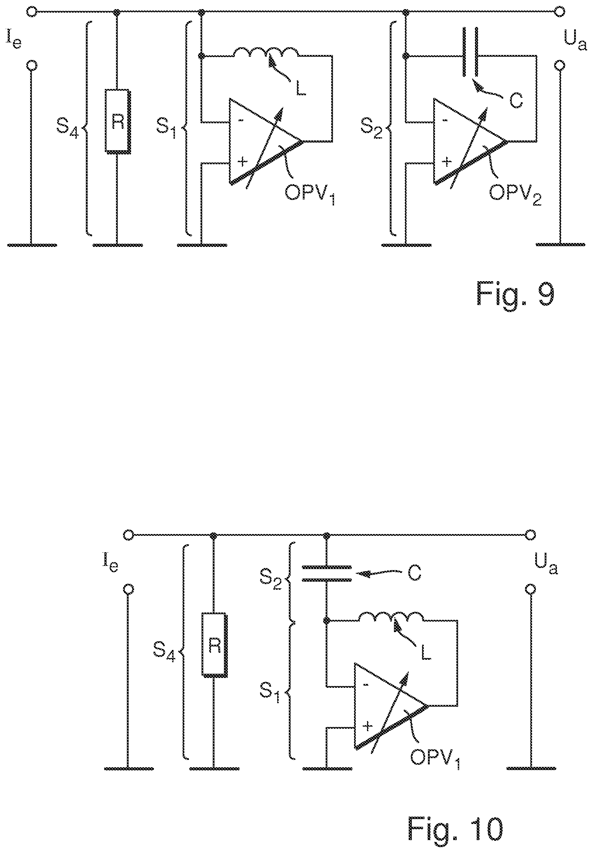

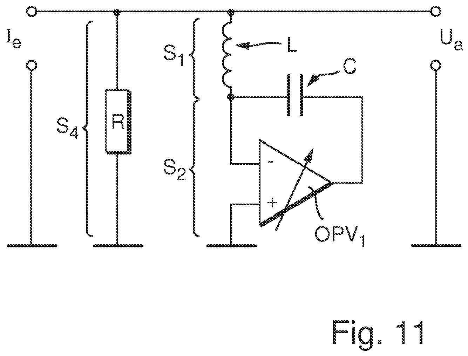

In dem Fall entfällt der in Serie zu dem jeweiligen Schwingkreis geschaltete dritte Schaltungszweig S3 mit dem Widerstand R. Stattdessen wird dem jeweiligen Schwingkreis ein weiterer Schaltungszweig S4 vorgeschaltet, der parallel zum Schwingkreis geschaltet ist, und in dem ein Widerstand R angeordnet ist. Dies ist in Fig. 7 am Beispiel des Bandpassfilters von Fig. 2, in Fig. 8 am Beispiel des Bandpassfilters von Fig. 3, in Fig. 9 am Beispiel des Bandpassfilters von Fig. 4, in Fig. 10 am Beispiel der Bandsperre von Fig. 5 und in Fig. 11 am Beispiel der Bandsperre von Fig. 6 dargestellt.

Die oben für die in den Figuren 2 bis 6 dargestellten Filter angegebenen Formeln für die einstellbare Induktivität $L_{eff}$, die einstellbare Kapazität $C_{eff}$, Resonanzfrequenz $f_0$ und die Bandbreite B der jeweiligen Filter gelten analog, wobei in den oben angeführten Formeln an die Stelle des in Serie im dritten Schaltungszweig S3 vorgeschalteten Widerstands R der im vierten Schaltungszweig S4 angeordnete Widerstand R tritt.

Die erfindungsgemäßen Filter weisen den Vorteil auf, dass zur Einstellung der Filterfrequenz, also der Mittenfrequenz der Bandpassfilter bzw. der Sperrfrequenz der Bandsperren nur geringe Verstärkungen $V_L$, $V_C$ benötigt werden. Des Weiteren werden keine einstellbaren Widerstände benötigt, und über Widerstände abfallende Spannungen bzw. darüber fließende Ströme werden nicht verstärkt. Dementsprechend erfolgt bei den erfindungsgemäßen Filtern auch keine Verstärkung des in Verbindung mit ohmschen Widerständen zwangsläufig auftretenden Rauschens. Entsprechend sind die Filter, insb. im Vergleich zu aktiven Filtern, extrem rauscharm.

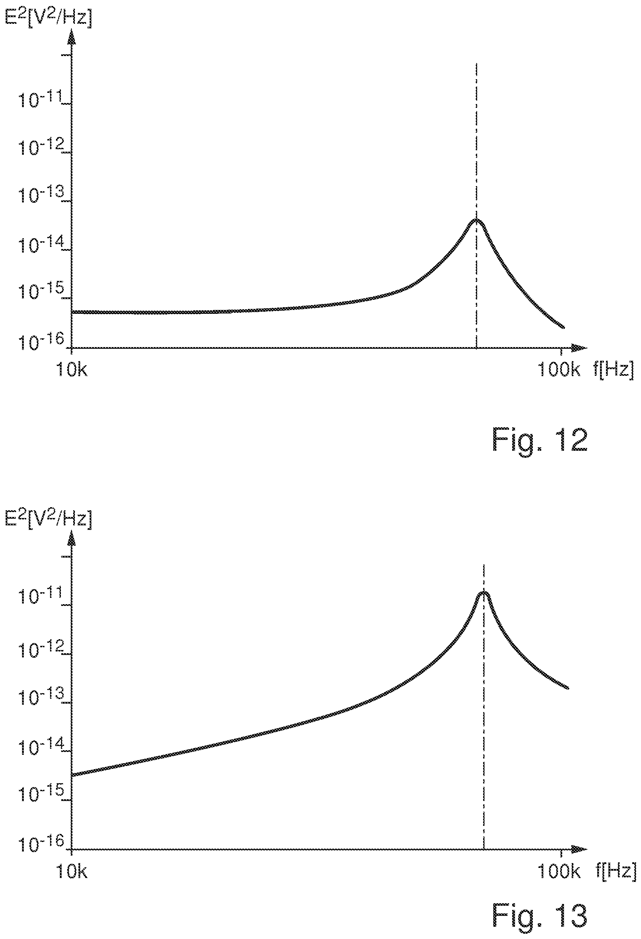

Fig. 12 zeigt in einer doppelt logarithmischen Darstellung das Quadrat der spektrale Energiedichte $E^2$ in $V^2$/Hz des Rauschens, hier des Spannungsrauschens, des in Fig. 2 dargestellten erfindungsgemäßen passiven Bandpassfilters in Abhängigkeit von der Frequenz f in Hz über einen Frequenzbereich von 10 kHz bis 100 kHz.

Im Vergleich dazu zeigt Fig. 13 ebenfalls in einer doppelt logarithmischen Darstellung das Quadrat der spektrale Energiedichte $E^2$ in $V^2$/Hz des Rauschens, hier des Spannungsrauschens, des in Fig. 1 dargestellten herkömmlichen aktiven Bandpassfilters in Abhängigkeit von der Frequenz f in Hz über den gleichen Frequenzbereich.

Für diesen Vergleich wurden die beiden Filter derart ausgelegt, dass sie die gleiche Mittenfrequenz und die gleiche Bandbreite aufweisen. Die beiden Kurven weisen jeweils bei der Mittenfrequenz ein ausgeprägtes Maximum auf. Wie aus den beiden Figuren 12 und 13 hervorgeht, liegt die spektrale Energiedichte des Rauschens des erfindungsgemäßen Filters jedoch über den gesamten dargestellten Frequenzbereich deutlich unterhalb der des herkömmlichen aktiven Bandpassfilters. Insb. beträgt der Unterschied in dem relevanten Bereich der Mittenfrequenz in dem dargestellten Vergleich sogar mehr als zwei Zehnerpotenzen.

**Bezugzeichen**

| | |
|---|---|
| $U_e$ | Eingangsspannung |
| $U_a$ | Ausgangsspannung |
| $I_e$ | Eingangsstrom |
| L | Induktivität |
| C | Kapazität |
| $S_1$ | erster Schaltungszweig |
| $S_2$ | zweiter Schaltungszweig |
| $S_3$ | dritter Schaltungszweig |
| $S_4$ | weiterer Schaltungszweig |
| $OPV_1$ | Verstärker |
| $OPV_2$ | Verstärker |
| R | Widerstand |

**Patentansprüche**

1. Analoges Bandpassfilter mit einstellbarer Mittenfrequenz mit

   - einem Parallelschwingkreis,

      -- dessen Resonanzfrequenz ($f_0$) gleich der Mittenfrequenz des Bandpassfilters ist,
      -- der einen ersten Schaltungszweig (S1) aufweist, in dem ein erstes frequenzbestimmendes Element angeordnet ist,
      -- der einen parallel zu dem ersten Schaltungszweig (S1) geschalteten zweiten Schaltungszweig (S2) aufweist, in dem ein zweites frequenzbestimmendes Element angeordnet ist, wobei
      -- das erste frequenzbestimmende Element eine Kapazität (C) ist, und

   - einem in den ersten Schaltungszweig (S1) eingesetzten ersten Verstärker ($OPV_1$) mit einstellbaren Verstärkung ($V_C$) und einem in den zweiten Schaltungszweig (S2) eingesetzten zweiten Verstärker ($OPV_2$) mit einstellbaren Verstärkung ($V_L$),

      - wobei die Verstärker im Betrieb eine über das in diesem Schaltungszweig (S1, S2) angeordnete frequenzbestimmende Element anliegende Spannung der eingestellten Verstärkung ($V_L$ oder $V_C$) entsprechend verstärken und dadurch eine entsprechende Veränderung eines durch das jeweilige frequenzbestimmende Element fließenden Stroms bewirken,

      **dadurch gekennzeichnet, dass**

      -- das zweite frequenzbestimmende Element eine Induktivität ist, und
-- der Ausgang der ersten Verstärker über das erste frequenzbestimmende Element mit dem invertierenden Eingang der ersten Verstärker verbunden ist, und der Ausgang der zweiten Verstärker über das zweite frequenzbestimmende Element mit dem invertierenden Eingang der zweiten Verstärker verbunden ist.

2. Analoges Bandpassfilter nach Anspruch 1, bei dem die eingestellte Verstärkung ($V_L$ oder $V_C$) von zumindest einem der zwei Verstärker ($OPV_1$ oder $OPV_2$) größer als 1 ist, und dieser Verstärker ($OPV_1$ oder $OPV_2$) den durch das entsprechende frequenzbestimmende Element fließenden Strom erhöht.

3. Analoges Bandpassfilter nach Anspruch 1, bei dem die eingestellte Verstärkung ($V_L$ oder Vc) von zumindest einem der zwei Verstärker ($OPV_1$ oder $OPV_2$) kleiner als 1 ist, und dieser Verstärker ($OPV_1$ oder $OPV_2$) den durch das entsprechende frequenzbestimmende Element fließenden Strom erniedrigt.

4. Analoges Bandpassfilter nach Anspruch 1, bei dem ein Ausgangssignal ($U_a$) des Bandpassfilters eine Ausgangsspannung ist, die über den Parallelschwingkreis abfällt.

5. Analoges Bandpassfilter nach Anspruch 1, bei dem ein Eingangssignal des Bandpassfilters eine Eingangsspannung ($U_e$) ist, die über einen dritten dem Parallelschwingkreis in Serie vorgeschalteten Schaltungszweig (S3), in dem ein Widerstand (R) angeordnet ist, an dem Parallelschwingkreis anliegt.

6. Analoges Bandpassfilter nach Anspruch 1, bei dem

   - ein Eingangssignal des Bandpassfilters ein Eingangsstrom ($I_e$) ist, und
   - dem Parallelschwingkreis ein weiterer Schaltungszweig (S4) vorgeschaltet ist,

      -- der parallel zum Parallelschwingkreis geschaltet ist, und
      -- in dem ein Widerstand (R) angeordnet ist.

**Claims**

1. Analog bandpass filter with an adjustable center frequency with

   - a parallel resonant circuit,

      -- whose resonance frequency ($f_0$) is equal to the center frequency of the bandpass filter,

-- which has a first branch circuit (S1) in which a first element that determines the frequency is arranged,

-- which has a second branch circuit (S2) - which is coupled in parallel to the first branch circuit (S1) - in which a second element that determines the frequency is arranged, wherein

-- the first element determining the frequency is a capacitance (C), and

- a first amplifier ($OPV_1$) with an adjustable amplification (Vc), inserted in the first branch circuit (S1), and a second amplifier ($OPV_2$) with an adjustable amplification ($V_L$), inserted in the second branch circuit (S2),

-- wherein, during operation, the amplifiers amplify a voltage present via the element determining the frequency which is arranged in this branch circuit (S1, S2) in a manner corresponding to the set amplification ($V_L$ or Vc) and, in this way, provoke a corresponding change in a current flowing through the relevant element determining the frequency,

**characterized in that**

-- the second element determining the frequency is an inductance, and

-- the output of the first amplifier is connected to the inverting input of the first amplifier via the first element that determines the frequency, and the output of the second amplifier is connected to the inverting input of the second amplifier via the second element determining the frequency.

2. Analog bandpass filter as claimed in Claim 1, wherein the set amplification ($V_L$ or Vc) of at least one of the two amplifiers ($OPV_1$ or $OPV_2$) is greater than 1, and said amplifier ($OPV_1$ or $OPV_2$) increases the current flowing through the corresponding element determining the frequency.

3. Analog bandpass filter as claimed in Claim 1, wherein the set amplification ($V_L$ or Vc) of at least one of the two amplifiers ($OPV_1$ or $OPV_2$) is less than 1, and said amplifier ($OPV_1$ or $OPV_2$) decreases the current flowing through the corresponding element determining the frequency.

4. Analog bandpass filter as claimed in Claim 1, wherein an output signal ($U_a$) of the bandpass filter is an output voltage which drops over the parallel resonant circuit.

5. Analog bandpass filter as claimed in Claim 1, wherein an input signal of the bandpass filter is an input voltage ($U_e$) which is applied at the parallel resonant circuit via a third branch circuit (S3) which is connected in series ahead of the parallel resonant circuit, wherein a resistor (R) is arranged in said branch circuit.

6. Analog bandpass filter as claimed in Claim 1, wherein

- an input signal of the bandpass filter is an input current ($I_e$), and
- an additional branch circuit (S4) is connected ahead of the parallel resonant circuit,

-- said circuit being coupled in parallel to the parallel resonant circuit, and
-- in which a resistor (R) is arranged.

**Revendications**

1. Filtre passe-bande analogique avec une fréquence centrale réglable avec

- un circuit résonant parallèle,

-- dont la fréquence de résonance ($f_0$) est égale à la fréquence centrale du filtre passe-bande,
-- qui comporte un circuit de dérivation (S1), dans lequel est disposé un premier élément déterminant la fréquence,
-- qui comporte un deuxième circuit de dérivation (S2) - couplé en parallèle au premier circuit de dérivation (S1) - dans lequel est disposé un deuxième élément déterminant la fréquence,
-- le premier élément déterminant la fréquence étant une capacité (C),

- un premier amplificateur ($OPV_1$) avec une amplification (Vc) réglable, inséré dans le premier circuit de dérivation (S1) et un deuxième amplificateur ($OPV_2$) avec une amplification ($V_L$) réglable, inséré dans le deuxième circuit de dérivation (S2),

-- les amplificateurs amplifiant de façon appropriée, en fonctionnement, une tension présente aux bornes de l'élément déterminant la fréquence disposé dans ce circuit de dérivation (S1, S2), et provoquant ainsi un changement correspondant d'un courant circulant à travers l'élément déterminant la fréquence respectif,

**caractérisé**

  -- **en ce que** le deuxième élément déterminant la fréquence est une inductance, et
  -- **en ce que** la sortie du premier amplificateur est reliée via le premier élément déterminant la fréquence avec l'entrée inverseuse du premier amplificateur, et la sortie du deuxième amplificateur est reliée via le deuxième élément déterminant la fréquence avec l'entrée inverseuse du deuxième amplificateur.

2. Filtre passe-bande analogique selon la revendication 1, pour lequel l'amplification ($V_L$ ou Vc) réglée sur au moins l'un des deux amplificateurs ($OPV_1$ ou $OPV_2$) est supérieure à 1, et cet amplificateur ($OPV_1$ ou $OPV_2$) augmentant le courant circulant à travers l'élément déterminant la fréquence correspondant.

3. Filtre passe-bande analogique selon la revendication 1, pour lequel l'amplification ($V_L$ ou Vc) réglée sur au moins l'un des deux amplificateurs ($OPV_1$ ou $OPV_2$) est inférieure à 1, et cet amplificateur ($OPV_1$ ou $OPV_2$) réduisant le courant circulant à travers l'élément déterminant la fréquence correspondant.

4. Filtre passe-bande analogique selon la revendication 1, pour lequel un signal de sortie ($U_a$) du filtre passe-bande est une tension de sortie, qui chute à travers le circuit résonant parallèle.

5. Filtre passe-bande analogique selon la revendication 1, pour lequel un signal d'entrée du filtre passe-bande est une tension d'entrée ($U_e$), qui est appliquée via un troisième circuit de dérivation (S3) couplé en amont et en série avec le circuit résonant parallèle, circuit de dérivation dans lequel est disposée une résistance (R).

6. Filtre passe-bande analogique selon la revendication 1, pour lequel

  - un signal d'entrée du filtre passe-bande est un courant d'entrée ($I_e$), et
  - un circuit de dérivation (S4) supplémentaire est couplé en amont du circuit résonant parallèle,

    -- lequel est commuté parallèlement au circuit résonant parallèle, et
    -- dans lequel est disposée une résistance (R).

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102006052873 A1
- US 4516041 A
- US 04644306 A1
- US 4383230 A